# EUROPEAN PATENT APPLICATION

(11) **EP 4 694 629 A1**
(43) Date of publication of application: **11.02.2026**
(21) Application number: 25194571.3
(22) Date of filing: 07.08.2025
(51) Int. Cl.: H10F 77/20, H10F 77/30, H10F 77/14, H10F 10/165

(54) **SOLAR CELL**

(30) Priority: 09.08.2024 CN 202411095535; 09.08.2024 CN 202411205043
(71) Applicant: CSI Cells (YangZhou) Co., Ltd., Yangzhou, Jiangsu 225000 (CN)
(72) Inventor: CHEN, Haiyan, Suzhou (CN); DENG, Weiwei, Suzhou (CN); YE, Xiaoya, Suzhou (CN)
(74) Representative: Epping - Hermann - Fischer

(57) **Abstract**

Provided is a solar cell. The solar cell includes a silicon substrate, a P-type doping structure located on the back surface of the silicon substrate, an N-type doping structure located on the back surface of the silicon substrate, a spacing region located between the P-type doping structure and the N-type doping structure, a first electrode located on a back surface of the P-type doping structure, and a second electrode located on a back surface of the N-type doping structure. In a first direction, the back surface of the P-type doping structure is higher than the back surface of the N-type doping structure, and the first direction is from a front surface of the silicon substrate to the back surface of the silicon substrate. With the solar cell of the present disclosure, on one hand, an overall surface area of the back surface is increased, and a light-receiving area is expanded, and on the other hand, both the back surface and at least part of a side surface of the P-type doping structure are exposed outwards, and a light-absorbing area of the P-type doping structure is increased. In this way, more carriers can be generated and successfully collected, improving a cell efficiency.

## Description

### FIELD

The present disclosure relates to the field of photovoltaics, and in particular, to a solar cell.

### BACKGROUND

A Back Contact (BC) cell has both its positive and negative electrodes located on a back surface of the BC cell, which can shorten a current transmission path and lower a resistance. Additionally, there is no grid line on a front surface of the BC cell, which can enhance a light absorption efficiency, thereby improving performance of the BC cell.

However, a back surface of a conventional BC cell provides an unsatisfactory light absorption effect, which hinders an improvement of a cell efficiency.

In view of this, it is necessary to provide an improved solar cell to address the above technical problems.

### SUMMARY

The present disclosure provides a solar cell, which can improve a height difference between a P-type doping structure and an N-type doping structure that are on a back surface of the solar cell, thereby enhancing light absorption and improving performance of the solar cell.

To achieve one of the above objectives of the present disclosure, the present disclosure adopts the following technical solutions.

A solar cell is provided. The solar cell includes: a silicon substrate; a P-type doping structure located on a back surface of a silicon substrate; an N-type doping structure located on the back surface of the silicon substrate; a spacing region located between the P-type doping structure and the N-type doping structure; a first electrode located on a back surface of the P-type doping structure; and a second electrode located on a back surface of the N-type doping structure. The back surface of the P-type doping structure is higher than the back surface of the N-type doping structure in a first direction. The first direction is from a front surface of the silicon substrate to the back surface of the silicon substrate.

In an optional embodiment, a height difference between the back surface of the P-type doping structure and the back surface of the N-type doped structure is 0.5 to 1.5 times a thickness of the P-type doping structure in the first direction.

In an optional embodiment, the P-type doping structure is formed by diffusing a P-type doping source from the back surface of the silicon substrate to a predetermined depth toward the front surface of the silicon substrate.

In an optional embodiment, the P-type doping structure includes a grid line region and a non-grid line region; the grid line region has a doping concentration greater than a doping concentration of the non-grid line region; and the first electrode is in contact with the grid line region.

In an optional embodiment, the grid line region has a sheet resistance ranging from 80 ohm/sq to 130 ohm/sq, and the non-grid line region has a sheet resistance ranging from 200 ohm/sq to 400 ohm/sq.

In an optional embodiment, the N-type doping structure is located in a region that is recessed from the back surface of the silicon substrate toward the front surface of the silicon substrate; the N-type doping structure is an N-type tunnel passivated contact structure disposed on a back surface of a recessed silicon substrate; the N-type tunnel passivated contact structure includes at least one first tunneling layer and an N-type doping polysilicon layer located at a side of each of the at least one first tunneling layer facing away from the back surface of the silicon substrate; and the second electrode is in contact with all of the N-type doping polysilicon layer.

In an optional embodiment, the N-type doping structure is located in a region that is recessed from the back surface of the silicon substrate toward the front surface of the silicon substrate; the N-type doping structure is an N-type tunnel passivated contact structure disposed on a back surface of a recessed silicon substrate; the N-type tunnel passivated contact structure includes at least two first tunneling layers and an N-type doping structure polysilicon layer located at a side of each of the at least two first tunneling layer facing away from the back surface of the silicon substrate; and the second electrode is in contact with at least one of the N-type doping polysilicon layers other than the N-type doping polysilicon layer closest to the silicon substrate.

In an optional embodiment, the N-type doping structure is located in a region that is recessed from the back surface of the silicon substrate to the front surface of the silicon substrate; and the N-type doping structure is formed by diffusing an N-type doping source from a back surface of a recessed silicon substrate to a predetermined depth toward a front surface of the recessed silicon substrate.

In an optional embodiment, the spacing region is formed by recessing from the back surface of the silicon substrate to the front surface of the silicon substrate; and a recess depth of the spacing region is 1 time to 1.5 times a diffusion depth of the P-type doping structure.

In an optional embodiment, the P-type doping structure is a P-type tunnel passivated contact structure located on the back surface of the silicon substrate; and the P-type tunnel passivated contact structure includes at least one second tunneling layer and a P-type doping polysilicon layer located at a side of each of the at least one second tunneling layer facing away from the back surface of the silicon substrate.

In an optional embodiment, the N-type doping structure is formed by diffusing an N-type doping source from the back surface of the silicon substrate to the front surface of the silicon substrate.

In an optional embodiment, the spacing region is formed by recessing from the back surface of the silicon substrate to the front surface of the silicon substrate; and a recess depth of the spacing region is 1 time to 1.5 times a diffusion depth of the N-type doping structure.

In an optional embodiment, the N-type doping structure is an N-type tunnel passivated contact structure disposed on the back surface of the silicon substrate; and the N-type tunnel passivated contact structure includes at least one first tunneling layer and an N-type doping polysilicon layer located at a side of each of the at least one first tunneling layer facing away from the back surface of the silicon substrate.

In an optional embodiment, a height difference between the back surface of the P-type doping structure and the back surface of the N-type doping structure ranges from 1 µm to 10 µm.

In an optional embodiment, the spacing region has a width ranging from 10 µm to 150 µm.

In an optional embodiment, the P-type doping structure has a width greater than a width of the N-type doping structure.

In an optional embodiment, the grid line region has a doping concentration ranging from 5E18cm⁻³ to 1E20cm⁻³.

In an optional embodiment, the front surface of the silicon substrate is provided with a textured structure.

In an optional embodiment, the solar cell further comprises: a back surface passivation layer disposed on the back surface of the P-type doping structure, a back surface of the spacing region, and the back surface of the N-type doping structure; and a back surface anti-reflection layer disposed on a back surface of the back surface passivation layer. The first electrode is in contact with the P-type doping structure by penetrating the back surface anti-reflection layer and the back surface passivation layer. The second electrode is in contact with the N-type doping structure by penetrating the back surface anti-reflection layer and the back surface passivation layer.

In an optional embodiment, the solar cell further comprises: a front surface passivation layer and a front surface anti-reflection layer sequentially disposed on the front surface of the silicon substrate.

The present disclosure can provide the following advantageous effects. With the solar cell of the present disclosure, on one hand, an overall surface area of the back surface is increased, and a light-receiving area is expanded, and on the other hand, both the back surface and at least part of a side surface of the P-type doping structure are exposed outwards, and a light-absorbing area of the P-type doping structure is increased. In this way, more carriers can be generated and successfully collected, improving a cell efficiency.

### BRIEF DESCRIPTION OF THE DRAWINGS

FIG. 1 is a schematic structural view of a solar cell according to an embodiment of the present disclosure.
FIG. 2 is a schematic structural view of a solar cell according to an embodiment of the present disclosure.
FIG. 3 is a schematic structural view of a solar cell according to an embodiment of the present disclosure.
FIG. 4 is a schematic structural view of a solar cell according to an embodiment of the present disclosure.
FIG. 5 is a schematic structural view of a solar cell according to an embodiment of the present disclosure.
FIG. 6 is a schematic structural view of a solar cell according to an embodiment of the present disclosure.
FIG. 7 is a schematic structural view of a solar cell according to an embodiment of the present disclosure.
FIG. 8 is a schematic structural view of a solar cell according to an embodiment of the present disclosure.
FIG. 9 is a schematic structural view of a solar cell according to an embodiment of the present disclosure.
FIG. 10 is a schematic structural view of a solar cell according to an embodiment of the present disclosure.
FIG. 11 is a schematic structural view of a solar cell according to an embodiment of the present disclosure.
FIG. 12 is a schematic structural view of a solar cell according to an embodiment of the present disclosure.
FIG. 13 is a schematic structural view of a solar cell according to an embodiment of the present disclosure.
FIG. 14 is a schematic structural view of a solar cell according to an embodiment of the present disclosure.
FIG. 15 is a schematic structural view of a solar cell according to an embodiment of the present disclosure.
FIG. 16 is a schematic structural view of a solar cell according to an embodiment of the present disclosure.

100: solar cell; 1: silicon substrate; 2: P-type doping structure; 21: grid line region; 22: non-grid line region; 23: second tunneling layer; 24: P-type doping polysilicon layer; 3: N-type doping structure; 31: first tunneling layer; 32: N-type doping polysilicon layer; 4: spacing region; 5: back surface passivation layer; 6: back surface anti-reflection layer; 7: front surface passivation layer; 8: front surface anti-reflection layer; 91: first electrode; 92: second electrode.

### DETAILED DESCRIPTION

The present disclosure will be described in detail below in combination with specific embodiments shown in the accompanying drawings, but these embodiments do not limit the present disclosure. Structural, methodological, or functional transformations made by those skilled in the art according to these embodiments shall fall within the scope of protection of the present disclosure.

In the accompanying drawings of the present disclosure, some dimensions of structures or parts are exaggerated relative to those of other structures or parts for ease of illustration, which is only intended to illustrate the basic structure of the subject matter of the present disclosure.

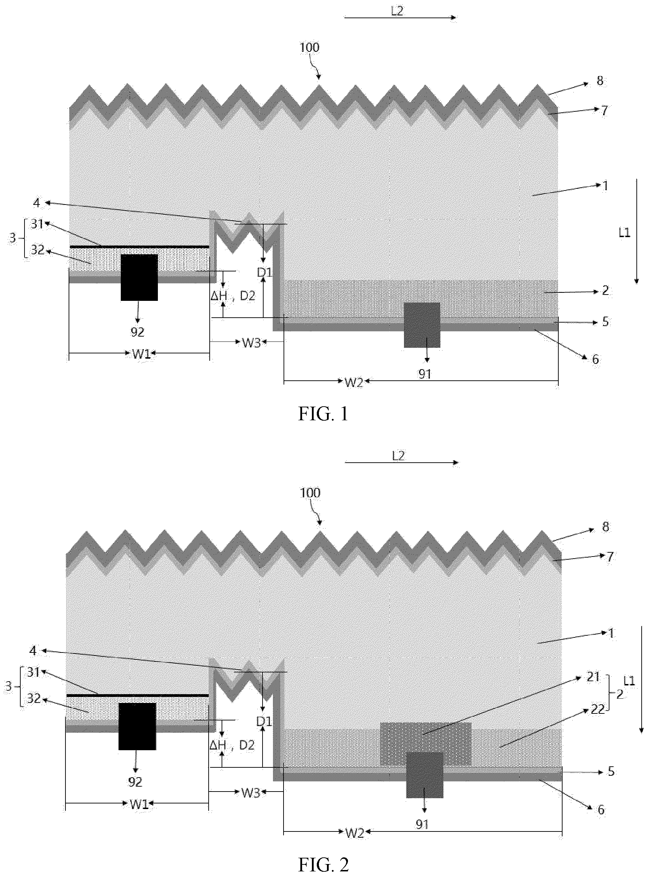

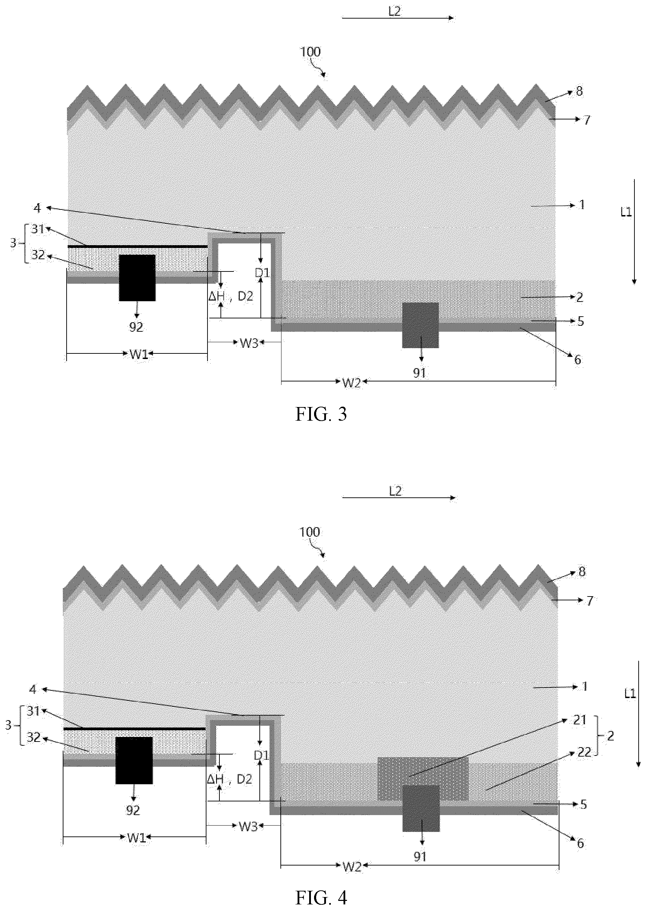

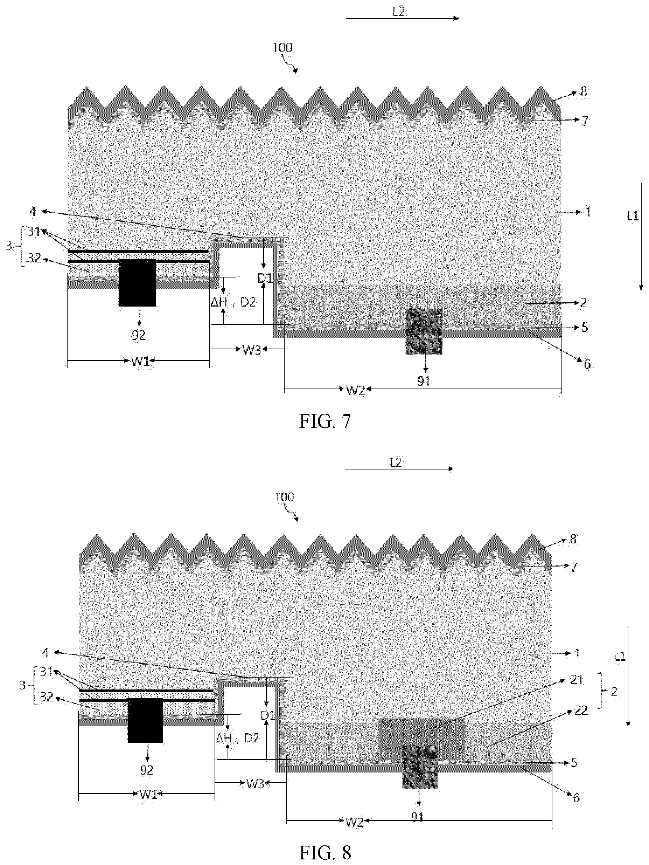

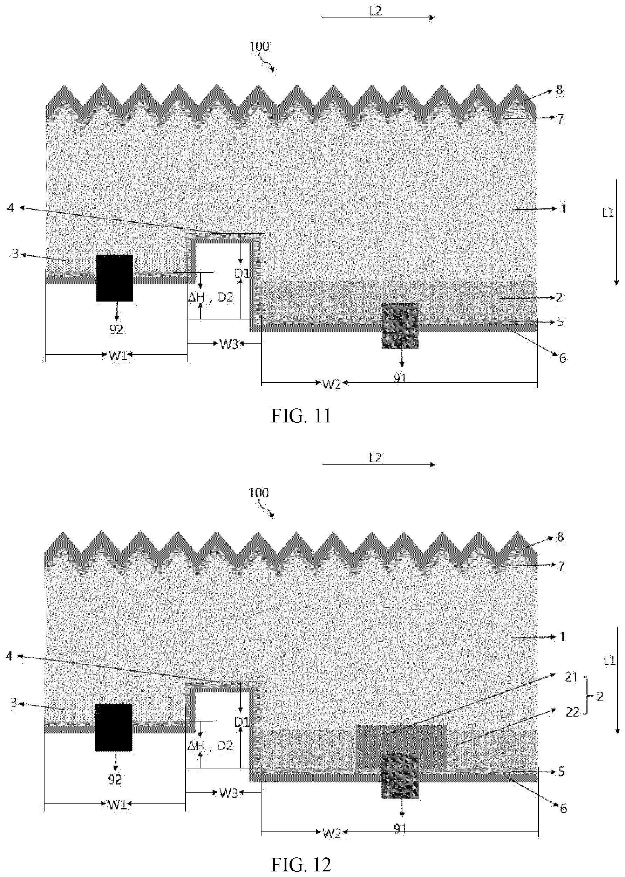

FIG. 1 to FIG. 16 illustrate a solar cell 100 according to embodiments of the present disclosure. The solar cell 100 includes a silicon substrate 1, a P-type doping structure 2 located on a back surface of the silicon substrate 1, an N-type doping structure 3 located on the back surface of the silicon substrate 1, a spacing region 4 located between the P-type doping structure 2 and the N-type doping structure 3, a first electrode 91 located on a back surface of the P-type doping structure 2, and a second electrode 92 located on a back surface of the N-type doping structure 3.

The silicon substrate 1 is selected as an N-type silicon wafer and has a resistivity ranging from 0.3 Ω·cm to 7 Ω·cm, preferably from 2 Ω·cm to 3.5 Ω·cm. In an optional embodiment, a front surface of the silicon substrate 1 is provided with a textured structure, which provides a satisfactory light-trapping effect, further improving light utilization.

The P-type doping structure 2 and the N-type doping structure 3 are alternately arranged and separated by the spacing region 4. By disposing each of the P-type doping structure 2 and the N-type doping structure 3 on the back surface of the silicon substrate 1, a current transmission path between the P-type doping structure 2 and the N-type doping structure 3 can be shortened, reducing a resistance. Additionally, by disposing the first electrode 91 and the second electrode 92 on the back surface of the P-type doping structure 2 and the back surface of the N-type doping structure 3, respectively, the front surface of the P-type doping structure 2 and the front surface of the N-type doping structure 3 is free from blocking by metallic electrodes, which results in a large light-receiving area of the solar cell 100, improving a cell efficiency.

A P-N junction is formed by the P-type doping structure 2 and the silicon substrate 1, while an N-N+ junction is formed by the N-type doping structure 3 and the silicon substrate 1. When a width W1 (the width W1 shown in the figures in the left-to-right direction) of the P-type doping structure 2 in a second direction L2 is greater than a width W2 (the width W2 shown in the figures in the left-to-right direction) of the N-type doped structure 3 in the second direction L2, since a length of the P-N junction and a length of the N-N⁺ junction (in a direction perpendicular to the plane of the figure) are equal, the area of the P-N junction on the plane perpendicular to the first direction L1 (i.e., the direction from the front surface of the silicon substrate 1 to the back surface of silicon substrate 1) is greater than the area of the N-N⁺ junction on the plane perpendicular to the first direction L1, which facilitates generation, separation, and collection of photo-generated carriers, thereby improving the cell efficiency.

In the present disclosure, the back surface of the P-type doping structure 2 is higher than the back surface of the N-type doping structure 3 in a first direction L1, and the first direction L1 is from the front surface of the silicon substrate 1 to the back surface of the silicon substrate 1. That is, the distance from the back surface of P-type doping structure 2 to the front surface of the silicon substrate 1 is greater than the distance from the back surface of N-type doping structure 3 to the front surface of the silicon substrate 1.

With the solar cell in the present disclosure, on one hand, an overall surface area of the back surface is increased, and a light-receiving area is expanded, and on the other hand, both the back surface and at least part of a side surface of the P-type doping structure 2 are exposed outwards, and a light-absorbing area of the P-type doping structure 2 is increased. In this way, more carriers can be generated and successfully collected, improving the cell efficiency.

In some embodiments, a height difference between the back surface of the P-type doping structure 2 and the back surface of the N-type doped structure 3 is 0.5 to 1.5 times a thickness of the P-type doping structure 2 in the first direction L1.

In a first type of embodiment, referring to FIG. 1 to FIG. 12, the P-type doping structure 2 is formed by diffusing a P-type doping source from the back surface of the silicon substrate 1 toward the front surface of the silicon substrate 1. For example, the P-type doping structure 2 is formed by diffusing a P-type doping source from the back surface of the silicon substrate 1 to a predetermined depth toward the front surface of the silicon substrate 1. The back surface of the silicon substrate 1 is same as the back surface of the P-type doping structure 2. In this case, the PN junction is located within the silicon substrate 1, which facilitates the separation and the collection of the carriers, thereby improving the cell efficiency.

The P-type doping source includes, but is not limited to, boron, aluminum, gallium, etc.

As illustrated in FIG. 1, FIG. 4, FIG. 5, FIG. 7, FIG. 9 and FIG. 11, a diffusion concentration of the P-type doping source in the P-type doping structure 2is uniform. As illustrated in FIG. 2, FIG. 4, FIG. 6, FIG. 8, FIG. 10 and FIG. 12, the P-type doping structure 2 includes a grid line region 21 and a non-grid line region 22, and the grid line region 21 has a doping concentration higher than a doping concentration of the non-grid line region 22.

Due to the higher doping concentration of the grid line region 21, the grid line region 21 forms an ohmic contact with the first electrode 91, which can reduce a series resistance of the solar cell 100 and improve a Fill Factor (FF) of the solar cell 100. In addition, the lower doping concentration of the non-grid line region 22 can reduce a surface recombination probability of carriers and decrease a reverse saturation current of the solar cell 100, thereby increasing an open-circuit voltage (Voc) and a short-circuit current (Isc) of the solar cell 100. Additionally, the grid line region 21 and the non-grid line region 22 can create a high-low junction P++/P+ or N++/N+ in the second direction L2, which helps improve the collection of the carriers, further improving the short-circuit current (Isc).

In an optional embodiment, the grid line region 21 has the doping concentration ranging from 5E18 cm⁻³ to 1E20 cm⁻³ and a sheet resistance ranging from 80 ohm/sq to 130 ohm/sq; and the non-grid line region 22 has a sheet resistance ranging from 200 ohm/sq to 400 ohm/sq.

The N-type doping structure 3 is located in a region that is recessed from the back surface of the silicon substrate 1 to the front surface of the silicon substrate 1.

In an embodiment, as illustrated in FIG. 1 to FIG. 8, the N-type doping structure 3 is an N-type tunnel passivated contact structure. The N-type tunnel passivated contact structure is disposed on a back surface of the recessed silicon substrate 1.

In an embodiment, the N-type tunnel passivated contact structure includes at least one first tunneling layer 31 and an N-type doping polysilicon layer 32 located at a side of each of the at least one first tunneling layer 31 facing away from the back surface of the silicon substrate 1. The second electrode 92 is in contact with all of the N-type doping polysilicon layer 32. As illustrated in FIG. 1 to FIG. 4, the N-type tunnel passivated contact structure includes one first tunneling layer 31 and a doping polysilicon layer 32 located at a side of the first tunneling layer 31 facing away from the back surface of the silicon substrate 1, and the second electrode 92 is in contact with the doping polysilicon layer 32.

In this way, it avoids direct contact between the second electrode 92 and the silicon substrate 1, improving the cell efficiency.

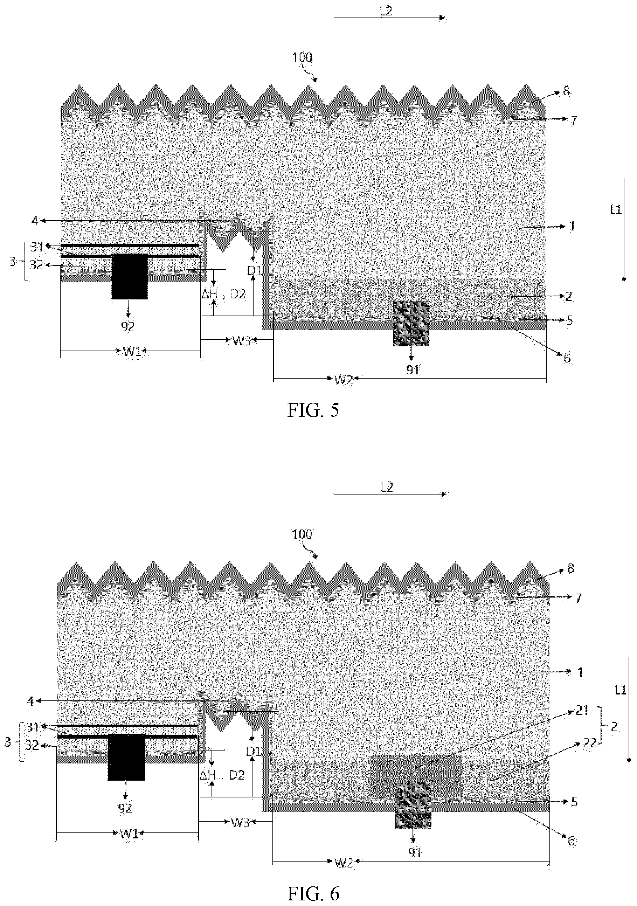

In some embodiments, the N-type tunnel passivated contact structure includes n first tunneling layer 31 and an N-type doping polysilicon layer 32 located at a side of each of the n first tunneling layer 31 facing away from the back surface of the silicon substrate 1, where n≥2. As illustrated in FIG. 5 to FIG. 8, the N-type tunnel passivated contact structure includes 2 first tunneling layers 31 and the doping polysilicon layer 32 located at the side of each of the 2 first tunneling layers 31 facing away from the back surface of the silicon substrate 1.

Multiple first tunneling layers 31 can prevent a metal silver from diffusing inwards to avoid a formation of a silicon-silver alloy due to contact of the metal silver with the silicon substrate 1.

In the first direction L1, the first N-type doping polysilicon layer 32, the second N-type doping polysilicon layer 32, ..., and the n-th N-type doping polysilicon layer 32 are sequentially arranged. The second electrode 92 is in contact with at least one of a 2nd doping polysilicon layer 32 to an n-th doping polysilicon layer 32. That is, the second electrode 92 is in contact with some or all of the N-type doping polysilicon layers 32 other than the N-type doping polysilicon layer 32 closest to the silicon substrate 1. The second electrode 92 would not reach the N-type doping polysilicon layer 32 closest to the silicon substrate 1, preventing silver from coming into direct contact with the silicon substrate.

In a specific embodiment, the N-type tunnel passivated contact structure includes two N-type doping polysilicon layers 32, and the second electrode 92 is only in contact with the N-type doping polysilicon layer 32 farthest from the silicon substrate 1.

In another specific embodiment, the N-type tunnel passivated contact structure includes three N-type doping polysilicon layers 32, and the second electrode 92 is only in contact with an outermost N-type doping polysilicon layer 32 farthest from the silicon substrate 1, or the second electrode 92 is not in contact with the N-type doping polysilicon layer 32 closest to the silicon substrate 1 and in contact with the other two N-type doping polysilicon layers 32.

Based on the above design, the first tunneling layer 31 is selected from a silicon oxide (SiOx) layer or a silicon carbide (SiC) layer and has a thickness ranging from 1 nm to 3 nm, preferably from 1 nm to 2.5 nm, and more preferably from 1 nm to 2 nm or from 1.5 nm to 2.5 nm. In the present disclosure, different thickness is selected based on a density of the first tunneling layer 31. When the first tunneling layer 31 is the SiOx layer, the first tunneling layer 31 has the thickness ranging from 1.4 nm to 2.3 nm. When the first tunneling layer 31 is the SiC layer, the first tunneling layer 31 is denser and has the thickness ranging from 1 nm to 1.8 nm.

The N-type doping polysilicon layer 32 is described with phosphorus doping. The N-type doping polysilicon layer 32 has a doping concentration ranging from 1E19 cm⁻³ to 1E21 cm⁻³, preferably from 1E20 cm⁻³ to 9E20 cm⁻³; and the N-type doping polysilicon layer 32 has the thickness ranging from 80 nm to 120 nm, which can be 90 nm, 85 nm, 100 nm, 105 nm, 110 nm, or 115 nm.

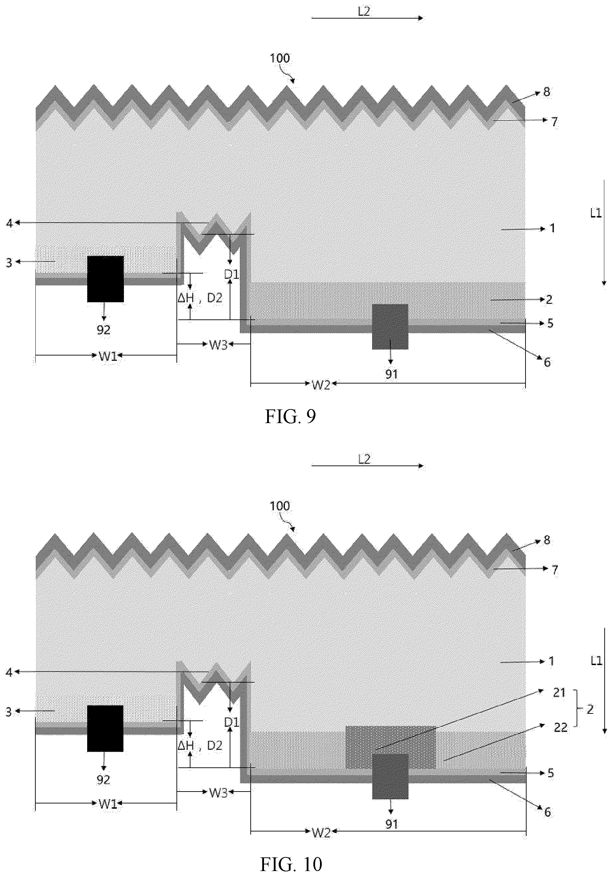

In another embodiment, as illustrated in FIG. 9 to FIG. 12, the N-type doping structure 3 is formed by diffusing an N-type doping source from the back surface of the silicon substrate 1 to a predetermined depth toward the front surface of the silicon substrate 1.

In the first type of embodiment, a height difference ΔH between the back surface of the P-type doping structure 2 and the back surface of the N-type doping structure 3 is 0.5 times to 1.5 times a diffusion depth of the P-type doping structure 2. With an increase in the height difference ΔH between the back surface of the P-type doping structure 2 and the back surface of the N-type doping structure 3, an exposed area of the P-type doping structure 2 becomes greater, and thus light absorption becomes better and the cell efficiency becomes higher.

The spacing region 4 separates the P-type doping structure 2 from the N-type doping structure 3 to avoid a leakage issue caused by contact between the P-type doping structure 2 and the N-type doping structure 3.

In an embodiment, the spacing region 4 has a width W3 in the second direction L2 ranging from 10 µm to 150 µm. While enabling the separation to avoid the leakage, with a decrease in the width W3 of the spacing region 4 in the second direction L2, the recombination of carriers in the spacing region 4 becomes less, and the cell efficiency becomes higher. Preferably, the width W3 of the spacing region 4 in the second direction L2 ranges from 50 µm to 100 µm.

In the present disclosure, the spacing region 4 is formed by recessing from the back surface of the silicon substrate 1 to the front surface of the silicon substrate 1, and a recess depth D1 of the spacing region 4 (a distance between the back surface of the P-type doping structure 2 and the back surface of the silicon substrate 1 in the spacing region 4) is 1 time to 1.5 times the diffusion depth of the P-type doping structure 2, that is, the recess depth D1 of the spacing region 4 is greater than the diffusion depth of the P-type doping structure 2, ensuring that the P-type doping structure 2 is completely separated from the N-type doping structure 3 by the spacing region 4.

In an embodiment, the recess depth D2 at which the N-type doping structure 3 is located, i.e., the distance between the back surface of the N-type doping structure 3 and the back surface of the P-type doping structure 2, is smaller than the recess depth D1 of the spacing region 4, which completely separates the P-type doping structure 2 from the N-type doping structure 3 in both an extension direction and a thickness direction of the silicon substrate 1, providing a satisfactory separation effect.

In an embodiment, a distance between the back surface of the P-type doping structure 2 and the back surface of the N-type doping structure 3 in the thickness direction of the silicon substrate 1 ranges from 1 µm to 10 µm, which can increase the surface area of the back surface. The P-type doping structure 2 and the N-type doping structure 3 present a stepped shape together. The stepped shape can allow multiple reflections of light on the back surface, which is more conducive to the light absorption. Preferably, the height difference ΔH between the back surface of the P-type doping structure 2 and the back surface of the N-type doping structure 3 ranges from 4 µm to 10 µm.

Additionally, a back surface of the spacing region 4 is a flat surface, providing satisfactory passivation in this spacing region 4. With such a design, the cell efficiency can be improved by 0.1% to 0.2%, without changing other structures. Alternatively, a back surface of the spacing region 4 is provided with a textured structure.

Further, referring to FIG. 1 to FIG. 12, the solar cell 100 further includes: a back surface passivation layer 5 disposed on the back surface of the P-type doping structure 2, a back surface of the spacing region 4, and the back surface of the N-type doping structure 3 and a back surface anti-reflection layer 6 disposed on a back surface of the back surface passivation layer 5. The first electrode 91 is in contact with the P-type doping structure 2 by penetrating the back surface anti-reflection layer 6 and the back surface passivation layer 5. The second electrode 92 is in contact with the N-type doping structure 3 by penetrating the back surface anti-reflection layer 6 and the back surface passivation layer 5. For example, the first electrode 91 is in contact with the grid line region 21 by penetrating the back surface anti-reflection layer 6 and the back surface passivation layer 5. The second electrode 92 is in contact with the N-type doping polysilicon layer 32 by penetrating the back surface anti-reflection layer 6 and the back surface passivation layer 5.

The back surface passivation layer 5 is an aluminum oxide layer, providing satisfactory field passivation for the P-type doping structure 2 and satisfactory interface passivation for the N-type doping structure 3. In the present disclosure, the thickness of the back surface passivation layer 5 ranges from 3 nm to 6 nm.

The back surface anti-reflection layer 6 is selected from one or more of silicon nitride, silicon oxynitride, or silicon oxide to form laminated films and has a thickness ranging from 60 nm to 130 nm, which reduces reflectivity and improves light utilization.

In an optional embodiment, the solar cell 100 further includes a front surface passivation layer 7 and a front surface anti-reflection layer 8 sequentially arranged on the front surface of the silicon substrate 1, which passivates surface defects of the front surface of the silicon substrate 1. In the present disclosure, the front surface passivation layer 7 and the back surface passivation layer 5 are made of a same material and have a same thickness, allowing the front surface passivation layer 7 and the back surface passivation layer 5 to be deposited together; and the front surface anti-reflection layer 8 and the back surface anti-reflection layer 6 are made of a same material and have a same thickness, enabling the front surface anti-reflection layer 8 and the back surface anti-reflection layer 6 to be deposited in a same process.

Based on the above design, the P-type doping structure 2 is formed by diffusing a P-type doping source from the back surface of the silicon substrate 1 toward the front surface of the silicon substrate 1, while the N-type doping structure 3 is located in a region that is recessed from the back surface of the silicon substrate 1 toward the front surface of the silicon substrate 1, and the N-type doping structure 3 is the N-type tunnel passivated contact structure or is formed by diffusing the N-type doping source from the back surface of the recessed silicon substrate 1 toward the front surface of the recessed silicon substrate 1.

In a structural design, the P-type doping structure 2 can be formed on the back surface of the silicon substrate 1 through diffusion, the diffusion junctions on some regions can be removed, and then the tunnel passivated contact structure can be deposited, and thus this structural design is highly compatible with a manufacturing process of TOPCon cells and suitable for industrial advancement.

A method for preparing a solar cell is described below. The P-type doping structure 2 has a boron doping source as the doping source and the N-type doping structure 3 is a phosphorus-doped N-type tunnel passivated contact structure.

S1: a P-type diffusion region (a boron junction) and BSG (borosilicate glass) are formed on the back surface of the silicon substrate 1 using a boron diffusion process.

S11: a boron source is formed over the entire back surface of the silicon substrate 1. The silicon substrate 1 is fixed in a quartz boat and supplied into a tubular furnace. A boron source and oxygen are introduced to deposit a layer of boron source (which can be referred to as a source introduction) on the back surface of the silicon substrate 1. The boron source may be boron trichloride (BCl₃), in which case the boron trichloride has a flow rate ranging from 90 sccm to 150 sccm, a flow rate of oxygen reacting with BCl₃ ranges from 100 sccm to 500 sccm, and a flow rate of oxygen for generating an oxide layer ranges from 1 slm to 10 slm. Alternatively, the boron source may be boron tribromide (BBr₃), in which case a flow rate of boron tribromide ranges from 90 sccm to 150 sccm, a flow rate of oxygen reacting with BBr₃ ranges from 100 sccm to 500 sccm, and a flow rate of oxygen for generating the oxide layer ranges from 1 slm to 10 slm.

S12: laser scanning is performed on the position at which the grid line region 21 of the P-type doping structure 2 is located to form the heavily doped grid line region 21. Laser parameters: laser power 120 W, 63% power for cutting (operating); laser frequency 100 kHz, scan speed 25 m/s.

S13: diffusion is performed on the position at which the non-grid line region 22 of the P-type doping structure 2 is located.

In an optional embodiment, the heavily doped silicon substrate 1 is disposed in the tubular furnace, oxygen is introduced into the tubular furnace, a temperature in the tubular furnace ranges from 950°C to 1,000°C, and a flow rate of oxygen ranges from 10 slm to 15 slm. At the high temperature, the boron source in the position at which the non-grid line region 22 of the P-type doping structure 2 is located diffuses into the silicon substrate 1 to form the non-grid line region 22, while BSG is formed over the entire surface.

In an optional embodiment, subsequent to deposition of the boron source, the sheet resistance ranges from 120 ohm/sq to 170 ohm/sq; subsequent to laser scanning, the grid line region 21 has the doping concentration ranging from 5E18 cm⁻³ to 1E20 cm⁻³ and the sheet resistance ranging from 80 ohm/sq to 130 ohm/sq; and subsequent to high-temperature oxidation, the non-grid line region 22 has the sheet resistance ranging from 200 ohm/sq to 400 ohm/sq.

Boron has a diffusion depth ranging from 0.5 µm to 1.0 µm, and the P-type diffusion region has a dark saturation current density J0 ranging from 2 fA/cm² to 4 fA/cm², which can achieve balanced passivation with the N-type doping structure 3. The N-type doping structure 3 has a dark saturation current density J0 ranging from 1 fA/cm² to 3 fA/cm². When such an optimal passivation level is achieved, a nearly constant junction depth is established.

S2: the BSG and the boron junction outside the P-type doping structure 2 are removed.

S21: laser film slitting is performed outside the P-type doping structure 2 to remove the BSG outside the P-type doping structure 2. The laser has power ranging from 50 W to 120 W, preferably an ultraviolet picosecond laser or a green picosecond laser is adopted, which causes small damage and is cost-effective; or a femtosecond laser may be adopted.

S22: the boron junction outside the P-type doping structure 2 is removed.

The BSG on the front surface and the side surface of the silicon substrate 1 are removed using an HF (Hydrofluoric Acid) solution having a concentration ranging from 5% to 20% (volume concentration). In an optional embodiment, this operation is performed in a chain-type machine.

Then, polishing is performed to remove the boron junction outside the P-type doping structure 2 and the boron junction propagated from the front surface, while retaining the boron junction and the BSG of the P-type doping structure 2. In an optional embodiment, this operation is performed in a trough-type machine.

When removing the boron junction outside the P-type doping structure 2, the BSG on the front surface and the side surface and the boron junction propagated from the front surface are also removed, achieving a simple process and laying a solid foundation for subsequent operations.

S3: back surface tunnel passivated contact structure and mask layer: the first tunneling layer 31 and a phosphorus-doped amorphous silicon layer are grown on the entire back surface through PECVD (Plasma Enhanced Chemical Vapor Deposition) technology by in-situ doping, and then a mask layer is grown at an outermost side. The first tunneling layers 31 and the phosphorus-doped amorphous silicon layers are deposited alternately, that is, the tunnel passivated contact structure including the first tunneling layers 31 and the doping polysilicon layers 32 may be formed.

In an embodiment, the first tunneling layer 31 is the SiOx layer and has a thickness ranging from 1.4 nm to 2.3 nm.

In another embodiment, the first tunneling layer 31 is the SiC layer, which is denser, and has a thickness ranging from 1 nm to 1.8 nm.

An n-poly layer has a thickness ranging from 80 nm to 120 nm.

The mask layer is a silicon oxide layer and has a thickness controlled to range from 10 nm to 50 nm.

S4: a high-temperature annealing furnace is adopted. An annealing temperature can be matched based on tunneling conditions. When the first tunneling layer 31 has a higher thickness, a higher annealing temperature is adopted. In an optional embodiment, the annealing temperature ranges from 850°C to 950°C, which matches well with the conventional first tunneling layer 31, ensuring that the n-poly region tested by electrochemical doping concentration (Electrochemical Capacitance-Voltage, ECV test) has a doping concentration ranging from 1E19 cm⁻³ to 1E21 cm⁻³.

In this process, the BSG layer remains within the first tunneling layer 31 at the position at which the P-type doping structure 2 is located, preventing inward diffusion of phosphorus. Outside the P-type doping structure 2, a phosphorus-doped region is formed by diffusing phosphorus inwards through the first tunneling layer 31 to the silicon substrate 1.

The annealing temperature is related to the density and the thickness of the first tunneling layer 31. In an optional embodiment, when the first tunneling layer 31 is the silicon oxide layer, and the first tunneling layer 31 has a thickness ranging from 1.4 nm to 2.3 nm, an annealing temperature ranges from 880°C to 950°C; and when the first tunneling layer 31 is the silicon carbide layer, and the first tunneling layer 31 has the thickness ranging from 1 nm to 1.8 nm, the annealing temperature ranges from 850°C to 900°C, ensuring that phosphorus outside the P-type doping structure 2 diffuses inwards to the silicon substrate 1.

S5: the mask layer, the N-type doping polysilicon layer 32, and the first tunneling layer 31 outside the N-type doping structure 3 which is spaced apart from the P-type doping structure 2 are removed.

S51: a laser process is adopted to remove the mask layer outside the N-type doping structure 3, exposing the N-type doping polysilicon layer 32 underlaying the mask layer. Laser parameters: laser power ranging from 50 W to 120 W, preferably the ultraviolet picosecond laser or the green picosecond laser is adopted. Laser causing smaller damage is more conducive to the laser film slitting.

S52: the chain-type machine and the HF solution are adopted to remove the mask layer propagated from the front surface.

S53: the trough-type machine and an alkaline solution are adopted to remove the N-type doping polysilicon layer 32 and the first tunneling layer 31 outside the N-type doping structure 3 on the back surface of the silicon substrate 1. In addition, etching is performed on the front surface of the silicon substrate 1 using the alkaline solution to form a pyramid structure on the exposed silicon substrate 1, followed by cleaning.

In the operation of S5, the film layers at the location of the N-type doping structure 3 and a location of the spacing region 4 may be removed in a patterned manner, resulting in different recess depths at the location of the N-type doping structure 3 and the location of the spacing region 4.

Compared with an operation of "forming a textured structure on the surface of the silicon substrate 1 and then preparing other film layers" in the related art, in the present disclosure, the pyramid structure is formed on the front surface subsequent to preparation of critical structures and film layers of the P-type doping structure 2 and the N-type doping structure 3. On one hand, it is unnecessary to polish the back surface of the silicon substrate 1 before boron diffusion. On the other hand, in the operation of S53, while the N-type doping polysilicon layer 32 and the first tunneling layer 31 are removed from the back surface, the pyramid structure is formed on the front surface, achieving multiple purposes. Additionally, the front surface of the silicon substrate 1 being the flat surface is more conducive to deposition and cleaning of film layers in the above operations.

Further, the boron junction between the P-type doping structure 2 and the N-type doping structure 3, the first tunneling layer 31, and the N-type doping polysilicon layer 32 have all been removed to form the spacing region 4, which avoids leakage between the P-type doping structure 2 and the N-type doping structure 3.

In the present disclosure, the width, depth, etc., of the spacing region 4 are as described above and thus details thereof will be omitted here.

S6: double-sided passivation. An ALD (Atomic Layer Deposition) process is adopted to deposit aluminum oxide on the front surface and the back surface. The aluminum oxide has a thickness ranging from 3 nm to 6 nm. Al₂O₃ provides satisfactory field passivation for the P-type doping structure 2 and satisfactory interface passivation for the N-type doping structure 3. In the present disclosure, preparing a double-sided passivation layer is an optional process step.

S7: double-sided anti-reflection layer, which may be laminated films formed by one or more of silicon nitride, silicon oxynitride, or silicon oxide. The anti-reflection layer has a thickness ranging from 60 nm to 130 nm. In the present disclosure, preparing the double-sided anti-reflection layer is an optional process step.

S8: electrode preparation. Electrodes are prepared using screen printing and sintering, including a main grid electrode on the back surface and auxiliary grid electrodes for the P-type doping structure 2 and the N-type doping structure 3 on the back surface.

S9: laser-assisted sintering (also known as Laser-Enhanced Contact Optimization, LECO) technology is adopted to perform laser sintering for the first electrode 91 and the second electrode 92. In this way, contact between silver and silicon in the electrodes can be improved to increase the cell efficiency by 0.2% to 0.3% or more. Further, modifications to an electrode paste are allowed, such as using silver-coated copper paste having a lower silver content, reducing costs.

The laser has a wavelength of 1,064 nm or 532 nm, and a width of 100 microns or ranging from 1 mm to 2 mm.

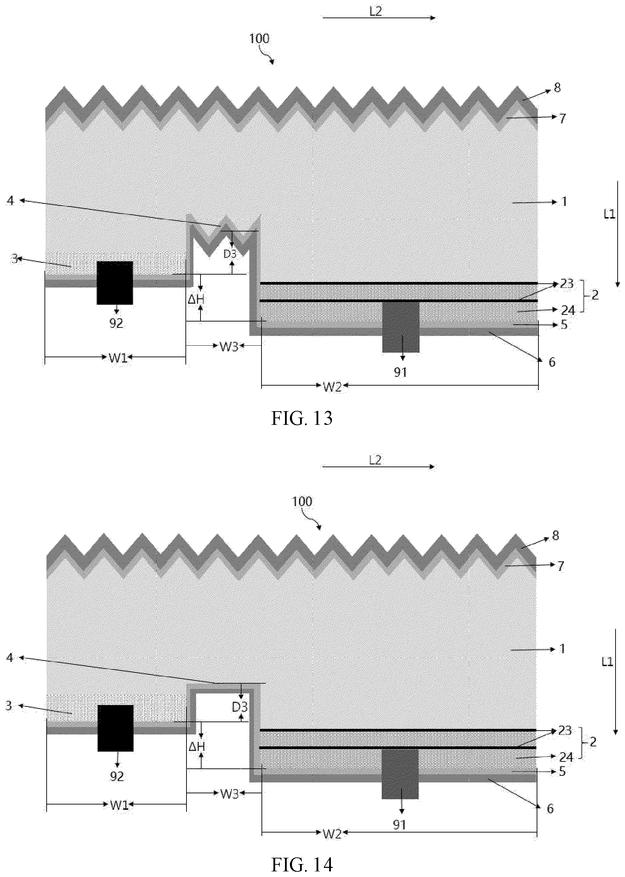

In a second type of embodiment, referring to FIG. 13 and FIG. 14, the P-type doping structure 2 is a P-type tunnel passivated contact structure located on the back surface of the silicon substrate 1. The second type of embodiment differs from the first type of embodiment only as described below, and thus other details will be omitted here.

The P-type tunnel passivated contact structure includes at least one second tunneling layer 23 and a P-type doping polysilicon layer 24 located at a side of each of the at least one second tunneling layer 23 facing away from the back surface of the silicon substrate 1. In this case, a height difference ΔH between the back surface of the P-type doping structure 2 and the back surface of the N-type doping structure 3 in the first direction L1 is 0.5 times to 1.5 times a thickness of the P-type tunnel passivated contact structure in the first direction L1.

Referring to FIG. 13 and FIG. 14, the N-type doping structure 3 is formed by diffusing an N-type doping source from the back surface of the silicon substrate 1 to the front surface of the silicon substrate 1.

Accordingly, the spacing region 4 is formed by recessing from the back surface of the silicon substrate 1 to the front surface of the silicon substrate 1. A recess depth D3 of the spacing region 4 (a distance between the back surface of the N-type doping structure 3 and the back surface of the silicon substrate 1) is 1 time to 1.5 times the diffusion depth of the N-type doping structure 3, which can allow the P-type doping structure 2 to be completely separated from the N-type doping structure 3.

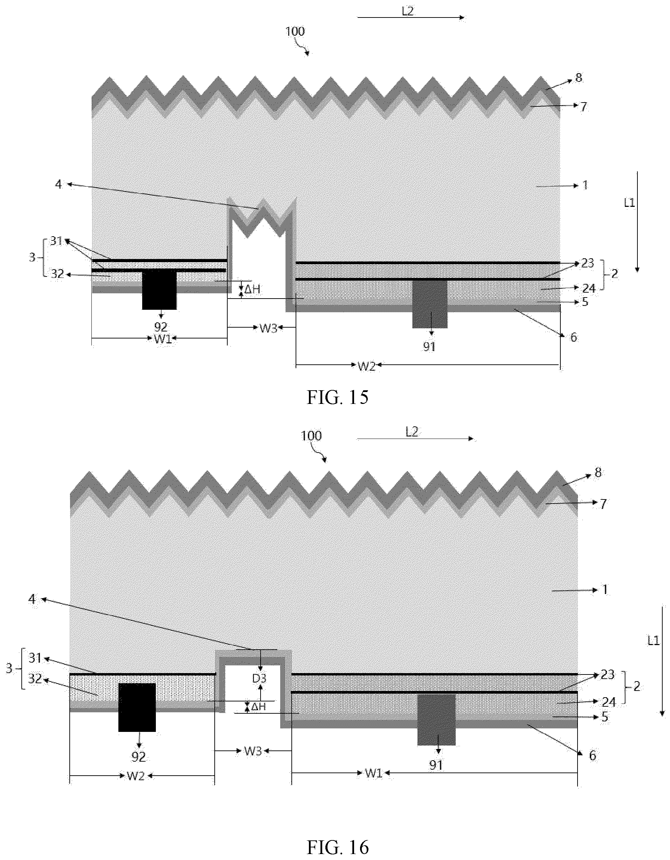

Referring to FIG. 15 and FIG. 16, the N-type doping structure 3 is an N-type tunnel passivated contact structure disposed on the back surface of the silicon substrate 1. The N-type tunnel passivated contact structure includes at least one first tunneling layer 31 and an N-type doping polysilicon layer 32 located at a side of each of the at least one first tunneling layer 31 facing away from the back surface of the silicon substrate 1.

This type of embodiment can use the following method for preparing the solar cell: preparing the P-type tunnel passivated contact structure over the entire back surface of the silicon substrate 1, and then performing a removal.

In this type of embodiment, the P-type doping structure 2 is the P-type tunnel passivated contact structure formed on the back surface of the silicon substrate 1, while the N-type doping structure 3 is located on the back surface of the silicon substrate 1 with the P-type tunnel passivated contact structure removed. The N-type doping structure 3 is the N-type tunnel passivated contact structure or is formed by diffusing the N-type doping source into the silicon substrate 1. With this structural design, the P-type doping structure 2 can be formed on the back surface of the silicon substrate 1 through diffusion, the P-type tunnel passivated contact structure on some regions can be removed, and then the N-type doping structure 3 can be formed, and thus this structural design is highly compatible with the manufacturing process of the TOPCon cells and suitable for industrial advancement.

A specific preparation method is described below.

S1: polishing. KOH or NaOH and an additive are adopted for alkaline polishing. Alternatively, the surface of the silicon substrate 1 is textured and then polished. A base in the region where the P-type doping structure 2 is located has a size ranging from 3 µm to 15 µm.

S2: preparation of the P-type doping structure 2.

S21: deposition of the tunneling layer/i-Poly using LPCVD (Low Pressure Chemical Vapor Deposition). The second tunneling layer 23 is grown on the back surface and has the thickness ranging from 1.2 nm to 2 nm. Then, an i-poly layer is grown and has a thickness ranging from 200 nm to 400 nm. Optionally, 0, 1, 2, ..., n second tunneling layers 23 may be grown within the poly layer.

S22: boron doping. Tube diffusion may be adopted. BCl₃ or BBr₃ may be used as a diffusion source. A temperature is controlled to range from 900°C to 1,100°C. A sheet resistance ranges from 50 ohm/sq to 500 ohm/sq. A BSG thickness ranges from 30 nm to 200 nm. A surface concentration ranges from 1E18 cm⁻³ to 1E20 cm⁻³.

S3: laser removal of the BSG: a laser treatment is performed on the back surface to remove the BSG in a patterned manner. The ultraviolet picosecond laser is adopted, and has spot power ranging from 3 W to 20 W, a spot size ranging from 100 µm to 150 µm, a frequency ranging from 500 kHz to 600 kHz, and a scan speed ranging from 40 m/s to 80 m/s. Alternatively, the green picosecond laser is adopted, and has spot power ranging from 5 W to 50 W, a spot size ranging from 100 µm to 500 µm, a frequency ranging from 500 kHz to 600 kHz, and a scan speed ranging from 40 m/s to 80 m/s.

S4: wet process using the chain-type machine and the trough-type machine. In the chain-type machine, the HF solution is used to remove the BSG from the front surface and the side surface of the silicon wafer. The trough-type machine performs a texturing treatment, removes the poly layer propagated from the front surface of the silicon wafer and the poly layer in the laser-treated region of the back surface, and forms a uniform textured structure on the front surface of the silicon substrate.

S5: diffusion. A high-temperature diffusion furnace is adopted. The high-temperature diffusion furnace has a temperature ranging from 850°C to 950°C. The n-poly region tested by ECV has a doping concentration ensured to range from 1E15 cm⁻³ to 1E21 cm⁻³. This operation can also involve double-sided diffusion, in such a manner that an n+ field can be formed on the front surface and an N+ field can be formed on an N-type region of the back surface.

S6: PSG removal using laser film slitting. The PSG at the location of the spacing region 4 between the P-type region and the N-type region on the back surface is removed in a patterned manner.

S7: alkaline etching is performed by the trough-type machine to prepare the spacing region 4, followed by cleaning.

S8: double-sided passivation. An ALD process is adopted to deposit aluminum oxide on the front surface and the back surface. The aluminum oxide has a thickness ranging from 3 nm to 6 nm. Al₂O₃ provides satisfactory field passivation for the P-type doping structure 2 and satisfactory interface passivation for the N-type doping structure 3. In the present disclosure, preparing the double-sided passivation layer is an optional process step.

S9: double-sided anti-reflection layer, which may be laminated films formed by one or more of silicon nitride, silicon oxynitride, or silicon oxide. The anti-reflection layer has a thickness ranging from 60 nm to 130 nm. In the present disclosure, preparing the double-sided anti-reflection layer is an optional process step.

S10: electrode preparation. Electrodes are prepared using screen printing and sintering, including a main grid electrode on the back surface and auxiliary grid electrodes for the P-type doping structure 2 and the N-type doping structure 3 on the back surface.

S11: laser-assisted sintering (also known as Laser-Enhanced Contact Optimization, LECO) technology is adopted to perform laser sintering for the first electrode 91 and the second electrode 92. In this way, contact between silver and silicon in the electrodes can be improved to increase the cell efficiency by 0.2% to 0.3% or more. Further, modifications to an electrode paste are allowed, such as using silver-coated copper paste having a lower silver content, reducing costs.

The laser has a wavelength of 1,064 nm or 532 nm, and a width of 100 microns or ranging from 1 mm to 2 mm.

In summary, with the solar cell 100 of the present disclosure, the first electrode 91 and the second electrode 92 are disposed at the back surface, leaving the front surface free of blocking by metallic electrodes. In this way, the large light-receiving area and a high light conversion efficiency are realized, improving the cell efficiency. In addition, by disposing an SE structure at the P-type doping structure 2, the open-circuit voltage and the short-circuit current of the cell are improved. Further, the passivated contact structure is disposed at the N-type doping structure 3 to passivate the surface, which further improves the short-circuit current, improving the cell efficiency as a whole.

It should be understood that, although the specification is described in accordance with the embodiments, not each embodiment contains only one independent technical solution. The specification is described in this manner only for the sake of clarity. Those skilled in the art should consider the specification as a whole. Also, the technical solutions in different embodiments can be combined appropriately to form other embodiments that can be understood by those skilled in the art.

The detailed descriptions set forth above are merely specific explanations for feasible embodiments of the present disclosure and are not intended to limit the scope of protection of the present disclosure. Any equivalent implementations or modifications made without departing from the spirit of the present disclosure shall fall within the scope of protection of the present disclosure.

## Claims

1. A solar cell, comprising:
a silicon substrate;
a P-type doping structure located on a back surface of the silicon substrate;
an N-type doping structure located on the back surface of the silicon substrate;
a spacing region located between the P-type doping structure and the N-type doping structure;
a first electrode located on a back surface of the P-type doping structure; and
a second electrode located on a back surface of the N-type doping structure, wherein:
the back surface of the P-type doping structure is higher than the back surface of the N-type doping structure in a first direction, the first direction being from a front surface of the silicon substrate to the back surface of the silicon substrate,
wherein a height difference between the back surface of the P-type doping structure and the back surface of the N-type doped structure is 0.5 to 1.5 times a thickness of the P-type doping structure in the first direction.

2. The solar cell according to claim 1, wherein:
the P-type doping structure is formed by diffusing a P-type doping source from the back surface of the silicon substrate to a predetermined depth toward the front surface of the silicon substrate.

3. The solar cell according to claim 2, wherein:
the P-type doping structure comprises a grid line region and a non-grid line region;
the grid line region has a doping concentration greater than a doping concentration of the non-grid line region; and
the first electrode is in contact with the grid line region.

4. The solar cell according to claim 3, wherein the grid line region has a sheet resistance ranging from 80 ohm/sq to 130 ohm/sq, and wherein the non-grid line region has a sheet resistance ranging from 200 ohm/sq to 400 ohm/sq.

5. The solar cell according to any one of claims 2 to 4, wherein:
the N-type doping structure is located in a region that is recessed from the back surface of the silicon substrate toward the front surface of the silicon substrate;
the N-type doping structure is an N-type tunnel passivated contact structure disposed on a back surface of a recessed silicon substrate;
the N-type tunnel passivated contact structure comprises at least one first tunneling layer and an N-type doping polysilicon layer located at a side of each of the at least one first tunneling layer facing away from the back surface of the silicon substrate; and
the second electrode is in contact with all of the N-type doping polysilicon layer.

6. The solar cell according to any one of claims 2 to 4, wherein:
the N-type doping structure is located in a region that is recessed from the back surface of the silicon substrate toward the front surface of the silicon substrate;
the N-type doping structure is an N-type tunnel passivated contact structure disposed on a back surface of a recessed silicon substrate;
the N-type tunnel passivated contact structure comprises at least two first tunneling layers and an N-type doping polysilicon layer located at a side of each of the at least two first tunneling layer facing away from the back surface of the silicon substrate; and
the second electrode is in contact with at least one of the N-type doping polysilicon layers other than the N-type doping polysilicon layer closest to the silicon substrate.

7. The solar cell according to any one of claims 2 to 4, wherein:
the N-type doping structure is located in a region that is recessed from the back surface of the silicon substrate to the front surface of the silicon substrate; and
the N-type doping structure is formed by diffusing an N-type doping source from a back surface of a recessed silicon substrate to a predetermined depth toward a front surface of the recessed silicon substrate.

8. The solar cell according to any one of claims 2 to 7, wherein:
the spacing region is formed by recessing from the back surface of the silicon substrate to the front surface of the silicon substrate; and
a recess depth of the spacing region is 1 time to 1.5 times a diffusion depth of the P-type doping structure.

9. The solar cell according to claim 1, wherein:
the P-type doping structure is a P-type tunnel passivated contact structure located on the back surface of the silicon substrate; and
the P-type tunnel passivated contact structure comprises at least one second tunneling layer and a P-type doping polysilicon layer located at a side of each of the at least one second tunneling layer facing away from the back surface of the silicon substrate.

10. The solar cell according to claim 9, wherein the N-type doping structure is formed by diffusing an N-type doping source from the back surface of the silicon substrate to the front surface of the silicon substrate.

11. The solar cell according to claim 10, wherein:
the spacing region is formed by recessing from the back surface of the silicon substrate to the front surface of the silicon substrate; and
a recess depth of the spacing region is 1 time to 1.5 times a diffusion depth of the N-type doping structure.

12. The solar cell according to claim 9, wherein:
the N-type doping structure is an N-type tunnel passivated contact structure disposed on the back surface of the silicon substrate; and
the N-type tunnel passivated contact structure comprises at least one first tunneling layer and an N-type doping polysilicon layer located at a side of each of the at least one first tunneling layer facing away from the back surface of the silicon substrate.

13. The solar cell according to any one of claims 1 to 12, wherein a height difference between the back surface of the P-type doping structure and the back surface of the N-type doping structure ranges from 1 µm to 10 µm.

14. The solar cell according to any one of claims 1 to 13, wherein the spacing region has a width ranging from 10 µm to 150 µm.

15. The solar cell according to any one of claims 1 to 14, wherein the P-type doping structure has a width greater than a width of the N-type doping structure.
